# EUROPEAN PATENT SPECIFICATION

(11) **EP 2 984 544 B1**
(45) Date of publication and mention of the grant of the patent: **20.04.2022**
(21) Application number: 14782387.6
(22) Date of filing: 10.04.2014
(51) Int. Cl.: G06F 3/041, H05K 5/03, B32B 17/10, B32B 27/08, B32B 27/28, B32B 27/36, B32B 7/12

(54) **POLYIMIDE COVER SUBSTRATE**
POLYIMIDABDECKSUBSTRAT
SUBSTRAT DE COUVERCLE EN POLYIMIDE

(30) Priority: 10.04.2013 KR 20130038944
(43) Date of publication of application: 17.02.2016
(73) Proprietor: Kolon Industries, Inc., Seoul 07793 (KR)
(72) Inventor: HONG, Ki ll, Yongin-si Gyeonggi-do 448-991 (KR); JUNG, Hak Gee, Yongin-si Gyeonggi-do 448-172 (KR)
(74) Representative: Ter Meer Steinmeister & Partner
(86) International application number: PCT/KR2014/003097
(87) International publication number: WO 2014/168423

(56) References cited:
- WO-A1-2008/072916
- US-A1- 2002 158 853
- US-A1- 2008 152 870
- US-A1- 2011 281 092
- US-A1- 2012 018 197
- US-A1- 2013 011 644
- US-B2- 7 663 312

## Description

### Technical Field

The present invention relates to a polyimide cover substrate useful as a cover substrate for a flexible electronic device.

### Background Art

Upon entering the ubiquitous computing era in which information is accessible anytime and anywhere due to rapidly evolving information technology, the need for handheld devices with portability and mobility is increasing. Accordingly, as an information device able to realize the ubiquitous computing era, the demand for a flexible display in which design modifications are free and which is flexible, lightweight and portable is increasingly emerging.

In order to achieve flexible type displays and to protect a substructure, a new type of flexible cover substrate is required in lieu of a conventional glass cover substrate. Also, such a cover substrate has to have high hardness and optical transmittance to protect parts provided in a display device, and also has to be in a thickness of a predetermined level or more to adopt existing processes without design changes.

Furthermore, if a conductive coating is added to the flexible cover substrate, a touch-integrated cover substrate, which enables screen touch, will be able to be provided.

US 2013/011644 A1 discloses a conductive multilayer structure comprising a substrate having opposite first and second surfaces, wherein the substrate has non-organic powders mixed therein, the thickness of the substrate is ranged from 100 to 125 micrometers; a transparent conductive film formed on the first surface; a hard-coated layer formed on the second surface; and a protective layer formed on the hard-coated layer; whereby the protective layer is a SiO2 layer. The non-organic powders mixed with the substrate may be selected from silicon oxide, and the substrate may be selected from polyimide. Said protective layer is formed on the hard-coated layer by a vacuum sputtering method, a chemical vapor deposition, or electron beam deposition, and instead of a SiO2, may be a silicon nitride film or photo-resist.

### Disclosure of Invention

### Technical Problem

Accordingly, the present invention has been made keeping in mind the above problems occurring in the related art, and an object of the present invention is to provide a polyimide cover substrate, which has a thickness of a predetermined level or more to implement processes, and may prevent generation of usual scratches in a flexible electronic device and may protect a substructure, and has conductivity to thus provide a touch-integrated transparent polyimide cover substrate which enable screen touch.

### Solution to Problem

In order to accomplish the above object, an embodiment of the present invention provides a polyimide cover substrate according to claim 1, which includes a first base layer, comprising a support film and a conductive coating layer formed on at least one surface of the support film; a second base layer, comprising a polyimide film and a hard coating layer formed on at least one surface of the polyimide film; an adhesive layer formed between the first base layer and the second base layer; and a silicon oxide layer formed on at least one surface of the polyimide film between the hard coating layer and adhesive layer, wherein said silicon oxide layer includes an unit structure represented by Chemical Formula 2 as defined on page 3.

In a preferred embodiment of the present invention, the support film has a total transmittance of 80% or more upon measurement of transmittance using a UV spectrophotometer based on a film thickness of 50 ~ 100 *µ*m, and has a thickness of 50 ~ 200 *µ*m.

In a preferred embodiment of the present invention, the support film is selected from the group consisting of a polyimide (PI) film, glass, a polyethyleneterephthalate (PET) film, a polycarbonate (PC) film and a polyethylenenaphthalate (PEN) film.

In a preferred embodiment of the present invention, the hard coating layer has a thickness of 1.0 ~ 90.0 *µ*m.

In a preferred embodiment of the present invention, the polyimide film has an average coefficient of linear thermal expansion (CTE) of 50.0 ppm/°C or less measured at 50 ~ 250°C by a TMA-method based on a film thickness of 50 ~ 100 *µ*m, and has a total transmittance of 80% or more upon measurement of color coordinates using a UV spectrophotometer, and a yellow index of 15 or less.

In a preferred embodiment of the present invention, the conductive coating layer has a thickness of 10 ~ 200 nm.

The polyimide cover substrate includes a silicon oxide layer formed on at least one surface of the polyimide film between the hard coating layer and the adhesive layer, said silicon oxide layer including unit structure represented by Chemical Formula 2 below: 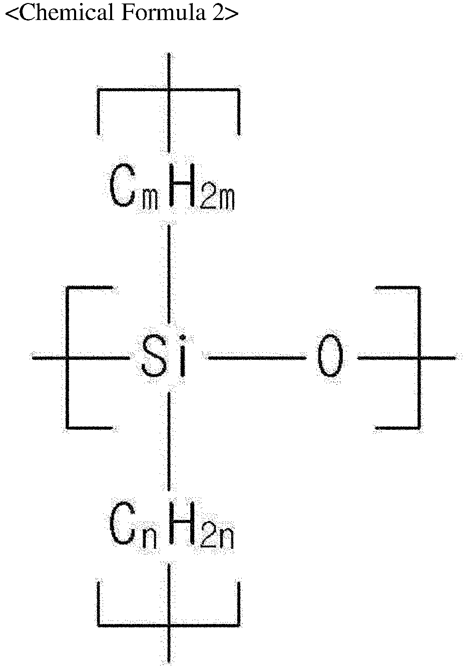 wherein m and n are each independently an integer of 1 ~ 10.

In a preferred embodiment of the present invention, the polyimide cover substrate has an average transmittance of 80% or more at 350 ~ 700 nm upon measurement of transmittance using a UV spectrophotometer based on a thickness of 200 ~ 600 *µ*m, and has a surface resistance of 10 Ω/m² or less, and a surface hardness of 7H or more.

### Advantageous Effects of Invention

According to the present invention, a transparent polyimide cover substrate has a thickness of a predetermined level or more to implement processes, and can exhibit superior optical properties, conductivity and scratch resistance. Such a transparent polyimide substrate can be effectively utilized as a cover substrate for a flexible electronic device.

### Brief Description of Drawings

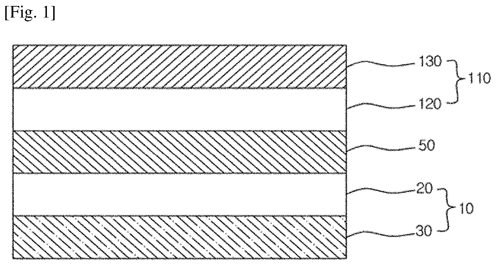

FIG. 1 is a cross-sectional view illustrating a polyimide cover substrate not according to the present invention.

### [Reference Numerals]

10: first base layer
20: support film
30: conductive coating layer
50: adhesive layer
110: second base layer
120: polyimide film
130: hard coating layer

### Mode for the Invention

Unless otherwise defined, all the technical and scientific terms used herein have the same meanings as those typically understood by those skilled in the art to which the present invention belongs. Generally, the nomenclature used herein is well known in the art and is typical.

As used herein, when any part "includes" or "contains" any element, this means that another element is not excluded but may be further included unless otherwise specifically mentioned.

The present invention addresses a polyimide cover substrate according to claim 1

Below is a detailed description of a polyimide cover substrate according to the present invention with reference to the appended drawing.

As illustrated in FIG. 1, the polyimide cover substrate according to the present invention is configured such that an adhesive layer 50 is disposed between a first base layer 10 and a second base layer 110.

The first base layer 10 includes a support film 20 and a conductive coating layer 30 formed on at least one surface of the support film 20.

Typically, a polyimide cover substrate is manufactured using glass having a thickness of 200 *µ*m or more and thus is designed so as to be adapted for glass 200 *µ*m or more thick. If the cover substrate becomes thin to the level of less than 200 *µ*m, its rigidity becomes lower compared to glass due to the properties of a polymer film, making it difficult to stably implement processes, and handling becomes more difficult compared to glass, and thus such a substrate may not be applied to processes.

In the present invention, the cover substrate includes the support film, having a thickness of 50 ~ 200 *µ*m and a total transmittance of 80% or more upon measurement of transmittance using a UV spectrophotometer based on a film thickness of 50 ~ 100 *µ*m, thereby satisfying a predetermined thickness of the cover substrate required of processes regardless of optical properties.

The optical transmittance in the above range was determined by measuring total transmittance using a spectrophotometer (CU-3700D, KONICA MINOLTA).

The support film 20 may be made of any material without limitation so long as it satisfies the transmittance range and the thickness range, and examples thereof may include a polyimide (PI) film, glass, a polyethyleneterephthalate (PET) film, a polycarbonate (PC) film, a polyethylenenaphthalate (PEN) film, etc.

In the polyimide cover substrate according to the present invention, the conductive coating layer 30 is formed on the support film 20, and thereby fabrication of a touch module is possible, ultimately providing a touch-integrated polyimide cover substrate which enables screen touch.

The conductive coating layer 30 may be made of any material without limitation so long as it is transparent and imparts conductivity, and preferable examples thereof may include indium-tin oxide (ITO), indium-zinc oxide (IZO), indium-tin-zinc oxide (ITZO), silver nanowires, metal mesh, graphene, etc.

Formation of the conductive coating layer 30 using a transparent conductive material may be performed by any process appropriately selected from among spraying, bar boating, spin coating, dip coating, sputtering, etc., and the conductive coating layer thus formed may be provided in the form of a multilayer where different transparent conductive materials are stacked in terms of conductivity.

The thickness of the conductive coating layer is preferably set to 10 ~ 200 nm in terms of conductivity and cost.

Meanwhile, the second base layer 110 is configured such that a hard coating layer 130 is formed on at least one surface of a polyimide film 120.

The polyimide film 120 may be used without limitation so long as it is a colorless transparent film which does not show inherent yellow of a polyimide film while having inherent heat resistance of a polyimide resin. Preferably useful is a polyimide film, having an average coefficient of linear thermal expansion (CTE) of 50.0 ppm/°C or less and preferably 35.00 ppm/°C or less measured at 50 ~ 250°C by a TMA-method based on a film thickness of 50 ~ 100 *µ*m, and a total transmittance of 80% or more upon measurement of transmittance using a UV spectrophotometer, with a yellow index of 15 or less.

If the average CTE exceeds 50.0 ppm/°C based on a film thickness of 50 ~ 100 *µ*m, a difference in CTE from a plastic substrate may increase and thus a short circuit may occur when the device is overheated or is at high temperature. If the yellow index exceeds 15 or the transmittance is less than 80%, transparency may decrease, making it impossible to apply the corresponding film to displays or optical devices. As such, the average CTE is obtained by measuring a change depending on the temperature rise in the predetermined temperature range, and may be measured using a thermomechanical analyzer.

The yellow index in the above range was measured by ASTM E313 using a spectrophotometer (CU-3700D, KONICA MINOLTA), and the average CTE was measured at 50 ~ 250°C by a TMA-method using TMA (Diamond TMA, PERKIN ELMER).

Also, the polyimide film according to the present invention has a thickness of 20 ~ 200 *µ*m. If the thickness of the polyimide film is less than 20 *µ*m, the layers other than polyimide may become thick to achieve a final required thickness of the corresponding substrate. In contrast, if the thickness thereof exceeds 200 *µ*m, it is difficult to mass produce polyimide at the corresponding thickness.

The polyimide film, which may satisfy such conditions, may be prepared by a typical preparation method from a resin including a unit structure derived from, as aromatic dianhydride, one or more selected from among 2,2-bis(3,4-dicarboxyphenyl)hexafluoropropane dianhydride (FDA), 9,9-bis(trifluoromethyl)-2,3,6,7-xanthene tetracarboxylic dianhydride (6FCDA), 4-(2,5-dioxotetrahydrofuran-3-yl)-1,2,3,4-tetrahydronaphthalene-1,2-dicarboxylic anhydride (TDA) and 4,4'-(4,4'-isopropylidenediphenoxy)bis(phthalic anhydride) (HBDA), and one or more selected from among pyromellitic dianhydride (PMDA), biphenyltetracarboxylic dianhydride (BPDA) and oxydiphthalic dianhydride (ODPA), and a unit structure derived from, as aromatic diamine, one or more selected from among 2,2-bis[4-(4-aminophenoxy)-phenyl]propane (6HMDA), 2,2'-bis(trifluoromethyl)-4,4'-diaminobiphenyl (2,2'-TFDB), 3,3'-bis(trifluoromethyl)-4,4'-diaminobiphenyl (3,3'-TFDB), 4,4'-bis(3-aminophenoxy)diphenylsulfone (DBSDA), bis(3-aminophenyl)sulfone (3DDS), bis(4-aminophenyl)sulfone (4DDS), 1,3-bis(3-aminophenoxy)benzene (APB-133), 1,4-bis(4-aminophenoxy)benzene (APB-134), 2,2'-bis[3(3-aminophenoxy)phenyl]hexafluoropropane (3-BDAF), 2,2'-bis[4(4-aminophenoxy)phenyl]hexafluoropropane (4-BDAF), 2,2'-bis(3-aminophenyl)hexafluoropropane (3,3'-6F), 2,2'-bis(4-aminophenyl)hexafluoropropane (4,4'-6F) and oxydianiline (ODA); or a resin including a unit structure derived from the above aromatic dianhydride, a unit structure derived from, as aromatic dicarbonyl compound, one or more selected from among p-terephthaloyl chloride (TPC), terephthalic acid, iso-phthaloyl dichloride and 4,4'-benzoyl chloride, and a unit structure derived from the above aromatic diamine. Alternatively useful is a commercially available polyimide film.

The hard coating layer 130 is formed on one or both surfaces of the polyimide film 120, and thereby functions to enhance scratch resistance of the cover substrate.

Curing of the hard coating layer may be performed through thermal curing or UV curing. In the case where UV curing is performed, a photoinitiator may be added to the solution including acrylate. Examples of the photoinitiator may include a benzoin ether photoinitiator, a benzophenone photoinitiator, and combinations thereof. UV curing may be carried out by irradiating UV at wavelengths of 312 and/or 365 nm in a dose of 1500 ~ 10,000 J/m².

The polyimide cover substrate according to the present invention includes a silicon oxide layer formed on at least one surface of the polyimide film between the hard coating layer and the adhesive layer, thereby improving solvent resistance, high heat resistance, etc. of the cover substrate.

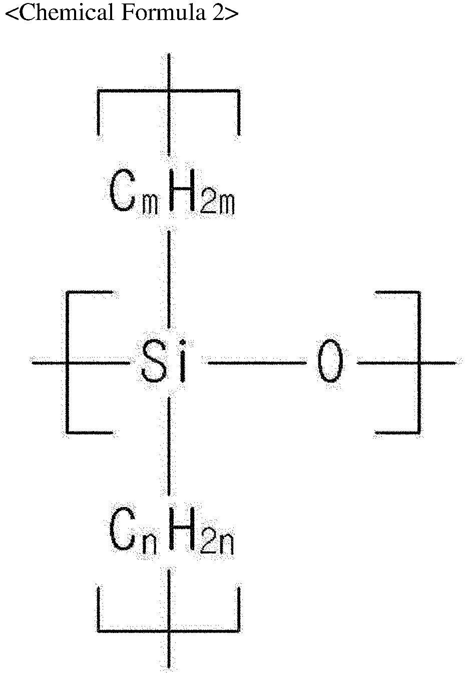

In Chemical Formula 2, m and n are each independently an integer of 1 10. To improve flexibility of the polyimide substrate, an alkyl chain having an appropriate length where n or m in Chemical Formula 2 is a natural number of 1 or more is favorably used. However, if n or m is 10 or more, a coating solution may agglomerate upon coating due to hydrophobic properties.

The silicon oxide layer preferably has a thickness of 0.3 ~ 2.0 *µ*m. The thickness thereof may be set to 0.3 *µ*m or more to sufficiently ensure appropriate solvent resistance, and may set to 2.0 *µ*m or less to prevent flexibility of the polyimide substrate from decreasing.

The polyimide cover substrate according to the present invention, including the silicon oxide layer, is favorable in terms of high transmittance, low yellow index and low water vapor transmission rate. Low water vapor transmission rate is essential for protecting TFT and OLED devices from external wet conditions.

Also, in the case where the polyimide cover substrate according to the present invention is configured such that the silicon oxide layer is formed on the surface of the polyimide film, its surface roughness (RMS) may be set to 2 nm or less, resulting in a flattened substrate. Thereby, carriers may be easily moved upon forming electrodes or TFT because of such flatness.

The method of forming the silicon oxide layer on one or both surfaces of the polyimide cover substrate according to the present invention may include applying a solution including polysilazane on one or both surfaces of the polyimide film and drying it, and curing the coated polysilazane.

Specifically, the silicon oxide layer is formed on at least one surface of the polyimide film in such a manner that polysilazane is applied and then cured, whereby the -NH-group of the unit structure of Chemical Formula 3 below may be converted into the -O-group of the unit structure of Chemical Formula 2 to form the silicon oxide layer. As such, curing is preferably performed through thermal curing at 200 ~ 300°C.

### <Chemical Formula 3>

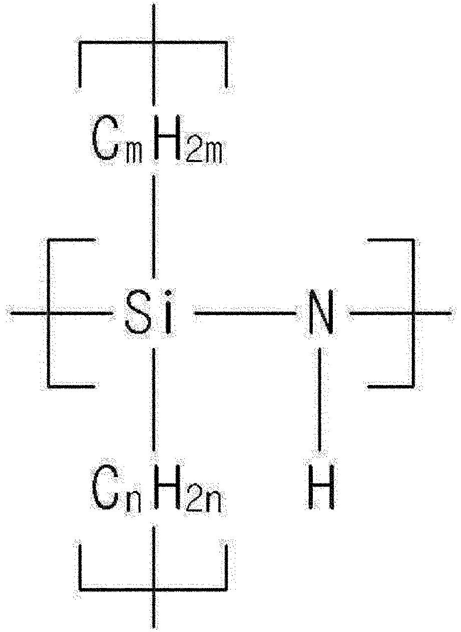

In Chemical Formula 3, m and n are each an integer of 1 ~ 10.

Such a thermal curing process facilitates the formation of a network structure necessary for obtaining the silicon oxide layer from polysilazane, and enables the film to become rigid, thus exhibiting excellent chemical resistance and heat resistance.

In the case where a thermal curing process is adopted, the coated polysilazane may be thermally treated at 200 ~ 300°C. When the thermal treatment temperature is set to 200°C or higher, the period of time required to cure polysilazane into the silicon oxide layer may be shortened. When the thermal treatment temperature is set to 300°C or less, problems in which CTE of the polyimide film may be different from that of the silicon oxide layer to thus distort the resulting substrate may be prevented.

PECVD or sputtering which is a typical deposition process to form an inorganic material on the surface of a film is restricted in the deposition area due to the limitation of vacuum equipment, but the method of applying the solution and curing it into an inorganic material according to the present invention may be executed by a simple casting process at atmospheric pressure, and is thus considerably advantageous in a large area and continuous process.

As such, polysilazane includes a unit structure of Chemical Formula 3, with a weight average molecule weight of 3,000 ~ 5,000 g/mol.

In Chemical Formula 3, m and n may be appropriately selected depending on the properties of a final silicon oxide. When the weight average molecular weight of polysilazane is set to 3,000 or more, higher solvent resistance and heat resistance may be ensured, and when it is set to 5,000 or less, uniform solution coatability may be attained.

Applying the solution including polysilazane on one or both surfaces of the transparent polyimide film may be performed using any process appropriately selected from among spraying, bar coating, spin coating, dip coating, etc.

The first base layer 10 and the second base layer 110 are adhered by the adhesive layer 50. The adhesive layer 50 may be made of any adhesive or film without limitation so long as it is transparent and is able to adhere the first base layer and the second base layer, and examples thereof may include an optical clear adhesive (OCA), a double adhesive tape (DAT), a UV curable resin, an optical clear resin (OCR), etc.

The adhesive layer has a thickness of 1 ~ 300 *µ*m. If the thickness thereof is less than 1 *µ*m, adhesion may become poor. In contrast, if the thickness thereof exceeds 300 *µ*m, the total thickness of the substrate may excessively increase, and adhesion thereof may deteriorate.

As mentioned above, as the polyimide cover substrate according to the present invention satisfies an average transmittance of 80% or more, a surface resistance of 10 Ω/m² or less, a surface hardness of 7H or more and a thickness of 200 *µ*m or more, it may be efficiently utilized as a cover substrate for a flexible electronic device.

A better understanding of the present invention may be obtained through the following examples which are set forth to illustrate, but are not to be construed as limiting the present invention.

### <Preparation Example>

While a 1 L reactor equipped with a stirrer, a nitrogen inlet tube, a dropping funnel, a temperature controller and a condenser was purged with nitrogen, 832 g of N,N-dimethylacetamide (DMAc) was placed, the temperature of the reactor was set to 25°C, 64.046 g (0.2 mol) of bistrifluoromethyl benzidine (TFDB) was dissolved, and this solution was maintained at 25°C. 31.09 g (0.07 mol) of 2,2-bis(3,4-dicarboxyphenyl)hexafluoropropane dianhydride (6FDA) and 8.83 g (0.03 mol) of biphenyltetracarboxylic dianhydride (BPDA) were added, and dissolved and reacted with stirring for a predetermined period of time. The temperature of the solution was maintained at 25°C. Furthermore, 20.302 g (0.1 mol) of terephthaloyl chloride (TPC) was added, thus obtaining a polyamic acid solution having a solid content of 13 wt%. The polyamic acid solution was added with 25.6 g of pyridine and 33.1 g of acetic anhydride, stirred for 30 min, further stirred at 70°C for 1 hr, cooled to room temperature, and precipitated with 20 L of methanol, after which the precipitated solid was filtered, ground and dried at 100°C for 6 hr in a vacuum, affording 111 g of polyimide in solid powder form.

Subsequently, 100 g of polyimide in solid powder form was dissolved in 670 g of DMAc, thus obtaining a 13 wt% solution. The solution thus obtained was applied onto a stainless plate, cast to 340 *µ*m, and dried using hot air at 130°C for 30 min, after which the resulting film was stripped from the stainless plate and then fixed to a frame with pins. The film-fixed frame was placed in a vacuum oven, slowly heated from 100°C to 300°C over 2 hr, and then slowly cooled, and a polyimide film was separated from the frame and then subjected to final thermal treatment at 300°C for 30 min.

The resulting polyimide film had a thickness of 50 *µ*m, a total transmittance of 88%, a yellow index of 3.0, and an average CTE of 20 ppm/°C measured at 50 ~ 250°C by a TMA- method.

### <Example 1, not according to the invention>

The same two polyimide films obtained in Preparation Example were laminated under conditions of 40°C, 2.1 m/m and 4kgf by means of an OCA film (3M) 125 *µ*m thick. Depending on the upper and lower surfaces of the films and transverse direction (TD) and machinery direction (MD) of the films upon lamination, properties such as transmittance, surface hardness, surface resistance, etc. may vary. In the corresponding example, the two polyimide films were laminated such that the upper surface A of one polyimide film and the lower surface B of the other polyimide film came into contact with each other, provided that the polyimide films were aligned in the same MD.

As for the laminated polyimide films, a solution of 5 ml of acrylate-containing polyisocyanate of Chemical Formula 1 in which R₁ is a hydrogen atom, m is 5 and n is 2 dissolved in 5 ml of propylene glycol monomethyl ether acetate (PGMEG) was applied on the upper polyimide film by means of a bar coater, and then dried at 80°C, thus obtaining a hard coating layer 10 *µ*m thick.

IZO, Ag and IZO were sequentially sputtered to thicknesses of 40 nm, 20 nm and 40 nm, respectively, under the lower polyimide film, thus forming a conductive coating layer 100 nm thick. The polyimide cover substrate thus manufactured was configured such that the conductive coating layer, the polyimide film, the adhesive layer, the polyimide film and the hard coating layer were sequentially stacked, and had a thickness of 200 *µ*m.

### <Example 2, not according to the invention>

A polyimide cover substrate was manufactured in the same manner as in Example 1, with the exception that the two polyimide films were laminated such that the upper surface A of one polyimide film and the upper surface A of the other polyimide film came into contact with each other. The cover substrate thus manufactured was 200 *µ*m thick.

### <Example 3, not according to the invention>

A polyimide cover substrate was manufactured in the same manner as in Example 1, with the exception that the two polyimide films were laminated such that the lower surface B of one polyimide film and the lower surface B of the other polyimide film came into contact with each other. The cover substrate thus manufactured was 200 *µ*m thick.

### <Example 4, not according to the invention>

A polyimide cover substrate was manufactured in the same manner as in Example 1, with the exception that the two polyimide films were laminated so as to alternate in MD and TD. The cover substrate thus manufactured was 200 *µ*m thick.

### <Example 5, not according to the invention>

A polyimide cover substrate was manufactured in the same manner as in Example 1, with the exception that a PET film (ASTROLL H11P, thickness 188 *µ*m, KOLON INDUSTRIES) was laminated on a polyimide film, instead of the two polyimide films. The polyimide cover substrate thus manufactured was configured such that the conductive coating layer, the PET film, the adhesive layer, the polyimide film and the hard coating layer were sequentially stacked, and had a thickness of 288 *µ*m.

As such, the PET film had a total transmittance of 92% upon measurement of transmittance using a UV spectrophotometer based on a thickness of 188 *µ*m.

### <Example 6, not according to the invention>

A polyimide cover substrate was manufactured in the same manner as in Example 5, with the exception that an adhering process was performed using a UV curable adhesive (Dynagrand KAB-1033, TOYOINK). The cover substrate thus manufactured was 288 *µ*m thick.

### <Example 7, not according to the invention>

A polyimide cover substrate was manufactured in the same manner as in Example 6, with the exception that an optical glass (LCD Bare Glass, NA32SG, thickness 500 *µ*m, SAMSUNG CORNING) was adhered onto a polyimide film, instead of the two polyimide films. The polyimide cover substrate thus manufactured was configured such that the conductive coating layer, the glass, the adhesive layer, the polyimide film and the hard coating layer were sequentially stacked, and had a thickness of 600 *µ*m.

As such, the glass had a total transmittance of 99% upon measurement of transmittance using a UV spectrophotometer based on a thickness of 500 *µ*m.

### <Comparative Example 1>

A cover substrate was manufactured in the same manner as in Example 1, with the exception that two PET films were adhered, instead of the two polyimide films. The cover substrate thus manufactured was configured such that the conductive coating layer, the PET film, the adhesive layer, the PET film and the hard coating layer were sequentially stacked, and had a thickness of 376 *µ*m.

### <Comparative Example 2>

A cover substrate was manufactured in the same manner as in Example 1, with the exception that a conductive coating layer was formed on one surface of a polyimide film, and a hard coating layer was formed on the other surface of the polyimide film opposite the surface having the conductive coating layer formed thereon. The cover substrate thus manufactured was configured such that the conductive coating layer, the polyimide film and the hard coating layer were sequentially stacked, and had a thickness of 100 *µ*m.

### <Comparative Example 3>

A cover substrate was manufactured in the same manner as in Example 1, with the exception that a conductive coating layer was formed on one surface of a PET film, and a hard coating layer was formed on the other surface of the PET film opposite the surface having the conductive coating layer formed thereon. The cover substrate thus manufactured was configured such that the conductive coating layer, the PET film and the hard coating layer were sequentially stacked, and had a thickness of 188 *µ*m.

### <Comparative Example 4>

A cover substrate was manufactured in the same manner as in Example 1, with the exception that a conductive coating layer was formed on one surface of a glass, and a hard coating layer was formed on the other surface of the glass opposite the surface having the conductive coating layer formed thereon. The cover substrate thus manufactured was configured such that the conductive coating layer, the glass and the hard coating layer were sequentially stacked, and had a thickness of 500 *µ*m.

### Table 1

**[Table 1]**

| No. | PI film | Adhesion surface of PI film | Adhesion direction of PI film | Support film | Adhesion surface of support film | Adhesion direction of support film | Adhesive layer |
|---|---|---|---|---|---|---|---|
| Ex. 1 | PI film | Lower surface B | MD | PI film | Upper surface A | MD | OCA |
| Ex. 2 | PI film | Upper surface A | MD | PI film | Upper surface A | MD | OCA |
| Ex. 3 | PI film | Lower surface B | MD | PI film | Lower surface B | MD | OCA |
| Ex. 4 | PI film | Lower surface B | MD | PI film | Upper surface A | TD | OCA |
| Ex. 5 | PI film | Lower surface B | MD | PET film | Upper surface A | MD | OCA |
| Ex. 6 | PI film | Lower surface B | MD | PET film | Upper surface A | MD | UV Curable resin |
| Ex. 7 | PI film | Lower surface B | MD | Glass | - | - | UV Curable resin |
| C.Ex. 1 | PET film | Upper surface A | MD | PET film | Upper surface A | MD | UV Curable resin |
| C.Ex. 2 | PI film | - | - | - | - | - | - |
| C.Ex. 3 | PET film | - | - | - | - | - | - |
| C.Ex. 4 | Glass | - | - | - | - | - | - |

### <Evaluation of properties>

The properties of the cover substrates were measured through the following procedures. The results are shown in Table 2 below.

### (1) Measurement of yellow index

A yellow index of each cover substrate was measured according to ASTM E313 using a spectrophotometer (CU-3700D, KONICA MINOLTA).

### (2) Measurement of average transmittance (%)

An optical transmittance of each cover substrate was measured at 350 ~ 700 nm using a spectrophotometer (CU-3700D, KONICA MINOLTA).

### (3) Measurement of surface resistance (Ω/m²)

Surface resistance of each cover substrate was measured ten times using a high resistance meter (Hiresta-UP MCT-HT450, MITSUBISHI CHEMICAL CORPORATION, and measurement range: 10×10⁵ ~ 10×10¹⁵) and a low resistance meter (CMT-SR 2000N, ADVANCED INSTRUMENT TECHNOLOGY (AIT), 4-Point Probe System, measurement range: 10×10³ ~ 10×10⁵) and then the measured values were averaged.

### (4) Measurement of pencil hardness

A line 50 mm long was drawn five times on each cover substrate with a Mitsubishi test pencil (UNI) at a rate of 180 mm/min under a load of 1 kg using an electric pencil hardness tester, after which pencil hardness was measured when there was no surface scratch.

### (5) Measurement of birefringence

Birefringence of each cover substrate was measured three times at 630 nm using a birefringence analyzer (Sairon SPA4000, PRISM COUPLER) and then the measured values were averaged.

### (6) Measurement of thickness

A thickness of each cover substrate was measured by contact of a thickness gauge (ANRITSU).

### Table 2

**[Table 2]**

| No. | Yellow index | Average transmittan ce | Surface resistance(Ω/ m²) | Surface hardness (H) | Thickness (*µ*m) | Birefringen ce |
|---|---|---|---|---|---|---|
| Ex. 1 | 2.84 | 90.34 | 6.1 | 9 | 200 | 0.0194 |
| Ex. 2 | 2.88 | 90.29 | 6.3 | 9 | 200 | 0.0203 |
| Ex. 3 | 2.87 | 90.35 | 6.1 | 9 | 200 | 0.0202 |
| Ex. 4 | 2.89 | 90.54 | 6.2 | 9 | 200 | 0.0198 |
| Ex. 5 | 2.13 | 90.81 | 6.3 | 9 | 288 | 0.199 |
| Ex. 6 | 2.53 | 90.32 | 6.4 | 9 | 288 | 0.203 |
| Ex. 7 | 10.51 | 83.80 | 6.1 | 9 | 600 | 0.0187 |
| C.Ex. 1 | 3.24 | 89.78 | 10.2 | 6 | 376 | 0.1574 |
| C.Ex. 2 | 1.59 | 91.02 | 6.2 | 9 | 100 | 0.0184 |
| C.Ex. 3 | 0.17 | 92.26 | 10.3 | 6 | 188 | 0.1574 |
| C.Ex. 4 | 0.00 | 99.05 | 6.4 | 9 | 500 | 0.0001 |

As is apparent from Table 2, in Examples 1 to 4, the properties including optical properties, surface hardness, surface resistance, etc., were satisfied regardless of the adhesion surface and direction of the polyimide films. In Examples 5 to 7, even when the PET film and the glass were used as the support film in addition to the polyimide film, the properties including surface hardness, etc. could be satisfactory due to the presence of the hard coating layer on the support film.

However, in Comparative Example 1 where the films for the first base layer and the second base layer were composed exclusively of PET films, the properties including surface resistance, surface hardness, etc. deteriorated. In Comparative Example 2, all the properties were satisfactory but the thickness was limited and thus this cover substrate was inadequate for use in the corresponding industrial fields. Also, in Comparative Example 3, almost all the properties were unsatisfactory, and in Comparative Example 4, most of the properties were satisfactory but this cover substrate could not be used for flexible electronic devices due to the use of glass alone.

## Claims

1. A polyimide cover substrate, comprising:
a first base layer, comprising a support film and a conductive coating layer formed on at least one surface of the support film;
a second base layer, comprising a polyimide film and a hard coating layer formed on at least one surface of the polyimide film; and
an adhesive layer formed between the first base layer and the second base layer, and
a silicon oxide layer formed on at least one surface of the polyimide film between the hard coating layer and the adhesive layer,
wherein the silicon oxide layer includes a unit structure represented by Chemical Formula 2 below: 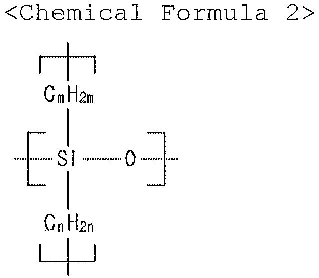 wherein m and n are each independently an integer of 1 ~ 10.

2. The polyimide cover substrate of claim 1, wherein the support film has a total transmittance of 80% or more upon measurement of transmittance using a UV spectrophotometer based on a film thickness of 50 ~ 100 *µ*m, and has a thickness of 50 ~ 200 *µ*m.

3. The polyimide cover substrate of claim 2, wherein the support film is selected from the group consisting of a polyimide film, glass, a polyethyleneterephthalate (PET) film, a polycarbonate (PC) film and a polyethylenenaphthalate (PEN) film.

4. The polyimide cover substrate of claim 1, wherein the hard coating layer has a thickness of 1.0 ~ 90.0 *µ*m.

5. The polyimide cover substrate of claim 1, wherein the polyimide film has an average coefficient of linear thermal expansion (CTE) of 50.0 ppm/°C or less measured at 50 ~ 250°C by a TMA-method based on a film thickness of 50 ~ 100 *µ*m, and has a total transmittance of 80% or more upon measurement of color coordinates using a UV spectrophotometer, and a yellow index of 15 or less.

6. The polyimide cover substrate of claim 1, wherein the conductive coating layer has a thickness of 10 ~ 200 nm.

7. The polyimide cover substrate of claim 1, wherein the polyimide cover substrate has an average transmittance of 80% or more at 350 ~ 700 nm upon measurement of transmittance using a UV spectrophotometer based on a thickness of 200 ~ 600 *µ*m, and has a surface resistance of 10 Ω/m² or less and a surface hardness of 7H or more.

## Patentansprüche

1. Polyimid-Abdecksubstrat, umfassend:
eine erste Basisschicht, umfassend eine Trägerfolie und eine leitfähige Beschichtungsschicht, die auf mindestens einer Oberfläche der Trägerfolie gebildet ist;
eine zweite Basisschicht, umfassend eine Polyimidfolie und eine Hartbeschichtungsschicht, die auf mindestens einer Oberfläche der Polyimidfolie gebildet ist; und
eine Klebeschicht, die zwischen der ersten Basisschicht und der zweiten Basisschicht gebildet ist, und
eine Siliziumoxidschicht, die auf mindestens einer Oberfläche der Polyimidfolie zwischen der Hartbeschichtungsschicht und der Klebeschicht gebildet ist,
wobei die Siliziumoxidschicht eine Struktureinheit enthält, die durch die folgende Chemische Formel 2 dargestellt wird: 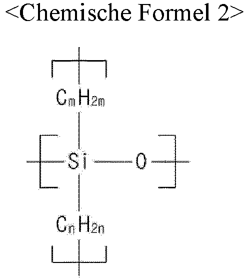 worin m und n jeweils unabhängig eine ganze Zahl von 1 ~ 10 sind.

2. Polyimid-Abdecksubstrat nach Anspruch 1, wobei die Trägerfolie eine Gesamttransmission von 80% oder mehr bei Messung der Transmission unter Verwendung eines UV-Spektrophotometers, basierend auf einer Foliendicke von 50 ~ 100 µm, aufweist und eine Dicke von 50 ~ 200 µm aufweist.

3. Polyimid-Abdecksubstrat nach Anspruch 2, wobei die Trägerfolie aus der Gruppe bestehend aus einer Polyimidfolie, Glas, einer Polyethylenterephthalat (PET)-Folie, einer Polycarbonat (PC)-Folie und einer Polyethylennaphthalat (PEN)-Folie. ausgewählt ist

4. Polyimid-Abdecksubstrat nach Anspruch 1, wobei die Hartbeschichtungsschicht eine Dicke von 1,0 ~ 90,0 µm aufweist.

5. Polyimid-Abdecksubstrat nach Anspruch 1, wobei die Polyimidfolie einen durchschnittlichen linearen Wärmeausdehnungskoeffizienten (CTE) von 50,0 ppm/°C oder weniger, gemessen bei 50 ~ 250°C durch ein TMA-Verfahren, basierend auf einer Foliendicke von 50 ~ 100 µm, aufweist und eine Gesamttransmission von 80% oder mehr bei Messung der Farbkoordinaten mit einem UV-Spektrophotometer und einen Gelbindex von 15 oder weniger aufweist.

6. Polyimid-Abdecksubstrat nach Anspruch 1, wobei die leitfähige Beschichtungsschicht eine Dicke von 10 ~ 200 nm hat.

7. Polyimid-Abdecksubstrat nach Anspruch 1, wobei das Polyimid-Abdecksubstrat eine durchschnittliche Transmission von 80 % oder mehr bei 350 ~ 700 nm bei Messung der Transmission unter Verwendung eines UV-Spektrophotometers, basierend auf einer Dicke von 200 ~ 600 µm, aufweist und einen Oberflächenwiderstand von 10 Ω/m² oder weniger und eine Oberflächenhärte von 7H oder mehr aufweist.

## Revendications

1. Substrat de recouvrement en polyimide, comportant :
une première couche de base, comportant un film de support et une couche de revêtement conductrice formée sur au moins une surface du film de support ;
une seconde couche de base, comportant un film de polyimide et une couche de revêtement dure formée sur au moins une surface du film de polyimide ; et
une couche adhésive formée entre la première couche de base et la seconde couche de base, et
une couche d'oxyde de silicium formée sur au moins une surface du film de polyimide entre la couche de revêtement dure et la couche adhésive,
dans lequel la couche d'oxyde de silicium inclut une structure unitaire représentée par la Formule chimique 2 ci-dessous : 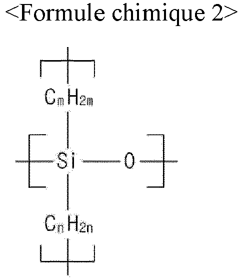 dans laquelle m et n représentent chacun, indépendamment l'un de l'autre, un entier de 1 à 10.

2. Substrat de recouvrement en polyimide selon la revendication 1, dans lequel le film de support a une transmittance totale de 80 % ou plus lors d'une mesure de transmittance utilisant un spectrophotomètre UV sur la base d'une épaisseur de film de 50 à 100 µm, et a une épaisseur de 50 à 200 µm,

3. Substrat de recouvrement en polyimide selon la revendication 2, dans lequel le film de support est choisi parmi le groupe constitué d'un film de polyimide, de verre, d'un film de poly(téréphtalate) d'éthylène (PET), d'un film de polycarbonate (PC) et d'un film de poly(naphtalate) d'éthylène (PEN).

4. Substrat de recouvrement en polyimide selon la revendication 1, dans lequel la couche de revêtement dure a une épaisseur de 1,0 à 9,0 µm,

5. Substrat de recouvrement en polyimide selon la revendication 1, dans lequel le film de polyimide a un coefficient moyen de dilatation thermique linéaire (CTE) de 50,0 ppm/°C ou moins mesuré à 50 à 250 °C par un procédé TMA sur la base d'une épaisseur de film de 50 à 100 µm, et a une thermistance totale de 80 % ou plus lors d'une mesure de coordonnées chromatiques utilisant un spectrophotomètre UV, et un indice de jaune de 15 ou moins.

6. Substrat de recouvrement en polyimide selon la revendication 1, dans lequel la couche de revêtement conductrice a une épaisseur de 10 à 200 µm,

7. Substrat de recouvrement en polyimide selon la revendication 1, dans lequel le substrat de recouvrement en polyimide a une transmittance moyenne de 80 % ou plus à 350 à 700 nm lors d'une mesure de transmittance utilisant un spectrophotomètre UV sur la base d'une épaisseur de 200 à 600 µm et a une résistance superficielle de 10 Ω/m² ou moins et une dureté superficielle de 7H ou plus.
